(19) Europäisches Patentamt
European Patent Office
Office européen des brevets

(11) EP 2 490 037 B1

(12) EUROPÄISCHE PATENTSCHRIFT

(45) Veröffentlichungstag und Bekanntmachung des Hinweises auf die Patenterteilung:
26.02.2014 Patentblatt 2014/09

(51) Int Cl.:
G01R 33/00 (2006.01)     G01R 33/07 (2006.01)

(21) Anmeldenummer: 12155990.0

(22) Anmeldetag: 17.02.2012

(54) **Kalibrierbarer Magnetfeldsensor und Verfahren zur Herstellung desselben**

Calibrating magnetic field sensor and method for manufacturing the same

Capteur de champ magnétique pouvant être calibré et son procédé de fabrication

(84) Benannte Vertragsstaaten:
AL AT BE BG CH CY CZ DE DK EE ES FI FR GB GR HR HU IE IS IT LI LT LU LV MC MK MT NL NO PL PT RO RS SE SI SK SM TR

(30) Priorität: 18.02.2011 DE 102011004391

(43) Veröffentlichungstag der Anmeldung:
22.08.2012 Patentblatt 2012/34

(73) Patentinhaber: Fraunhofer-Gesellschaft zur Förderung der angewandten Forschung e.V.
80686 München (DE)

(72) Erfinder:
• Stahl-Offergeld, Markus
91058 Erlangen (DE)
• Ernst, Roland
91052 Erlangen (DE)
• Hohe, Hans-Peter
91332 Heiligenstadt (DE)

(74) Vertreter: Zimmermann, Tankred Klaus et al
Schoppe, Zimmermann, Stöckeler
Zinkler & Partner
P.O. Box 246
82043 Pullach (DE)

(56) Entgegenhaltungen:
DE-A1-102006 037 226

• STAHL-OFFERGELD M ET AL: "Integrated sensitivity adjustment for 3D Hall sensors", SENSOR LETTERS, AMERICAN SCIENTIFIC PUBLISHERS, US, Bd. 7, Nr. 3, 1. Juni 2009 (2009-06-01), Seiten 313-316, XP009149085, ISSN: 1546-198X, DOI: 10.1166/SL.2009.1074

**Beschreibung**

Die vorliegende Erfindung bezieht sich auf einen kalibrierbaren Magnetfeldsensor mit einem vertikalen Hall-Sensorelement und auf ein Verfahren zur Herstellung desselben.

Zur Bestimmung der Empfindlichkeit eines Magnetfeldsensors wird durch Einprägen eines definierten Stroms in eine Spule oder einen Erregerleiter ein Magnetfeld mit möglichst bekannter magnetischer Flussdichte am Ort des Sensors erzeugt. Über die resultierende Änderung des Ausgangssignals des Magnetfeldsensors bei Anliegen eines Kalibriermagnetfelds kann dann auf die Empfindlichkeit des Sensors geschlossen werden. Bei einem Hall-Sensorelement kann also über eine Änderung der Hall-Spannung, die durch eine Änderung der magnetischen Flussdichte im Sensorelement hervorgerufen wird, auf die tatsächliche Empfindlichkeit des Hall-Sensorelements geschlossen werden.

Bei Erregerspulen oder Erregerleiterstrukturen kann das Problem entstehen, dass während der Herstellung des Magnetfeldsensors in einem Halbleitersubstrat die einzelnen Schichtstrukturen Prozessschwankungen, wie sie bei der Herstellung von Halbleiterbauelementen typischerweise auftreten, unterworfen sind. Diese Prozessschwankungen sind bei einem Halbleiterbauelement in vertikaler Richtung, d.h. in einer Richtung senkrecht zur Substratoberfläche, im Allgemeinen erheblich größer als in einer lateralen Richtung, d.h. in einer Ebene parallel zu der Halbleitersubstratoberfläche. Dementsprechend kann ein tatsächlicher Abstandswert zwischen dem aktiven Bereich des Hall-Sensorelements und der Erregerleiterstruktur von einem während der Herstellung angestrebten idealen Abstandswert abweichen. Da bei einer Kalibrierung des Magnetfeldsensors mittels eines von einem definierten Kalibrierstrom erzeugten Magnetfeldes auch die Lage bzw. der effektive Abstand der Erregerleitung zu dem aktiven Bereich des Hall-Sensorelements eingeht, kann es aufgrund von nicht berücksichtigten Prozesstoleranzen zu einer ungenauen Kalibrierung des Magnetfeldsensors kommen.

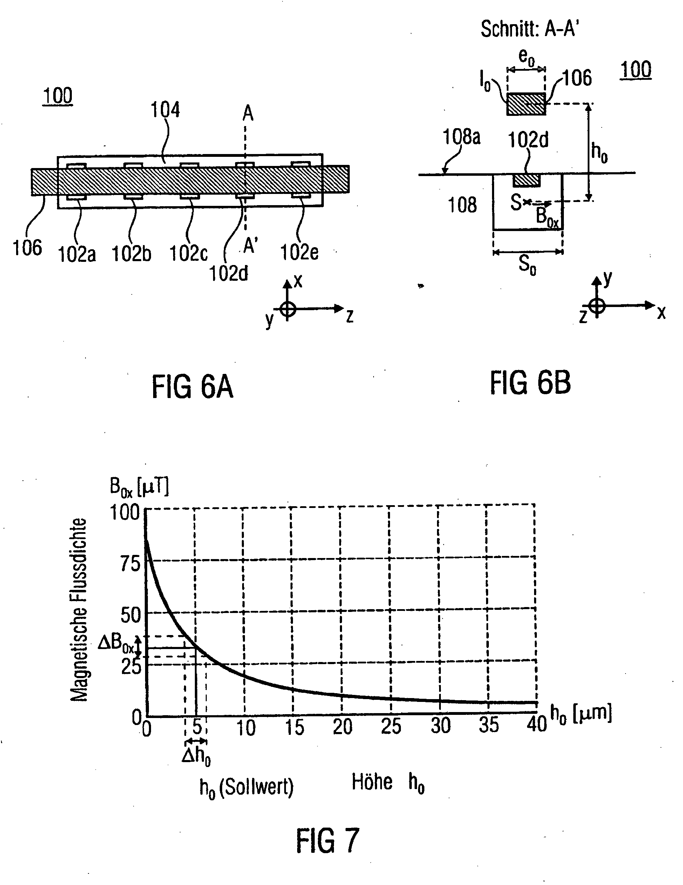

In den Figuren 6a-b ist eine Prinzipdarstellung in Form einer Draufsicht und einer Schnittansicht eines vertikalen Hall-Sensorelements 100 in einem Halbleitersubstrat 108 dargestellt. Mit vertikal ist eine Ebene senkrecht zur Halbleitersubstrat- bzw. Chipoberfläche 108a, also vertikal zur x-z-Ebene in Fig. 6a-b, gemeint. Das in den Figuren 6a-b dargestellte vertikale Hall-Sensorelement 100 weist fünf Kontaktbereiche 102a-e entlang der Hauptoberfläche des aktiven Halbleiterbereichs 104 auf. Vertikale Hall-Sensoren, die eine Magnetfeldkomponente $B_{0x}$ im aktiven Bereich parallel zur Substratoberfläche (in x-Richtung) erfassen können, können für eine Kalibrierung mittels eines mit einem Kalibrie-rungsstrom $I_0$ durchflossenen Erregerleiters 106 gezielt mit einer Kalibrierungsflussdichte $\vec{B}_0$ versehen werden. Der Erregerleiter 106 ist dabei, wie dies schematisch in Fig. 6a dargestellt ist, in einer Höhe $h_0$ oberhalb direkt bzw. senkrecht oberhalb des Hall-Sensorelements 100 angeordnet. Wie ferner in den Figuren 6a-b dargestellt ist, weist beispielsweise der aktive Bereich 104 des Hall-Sensorelements 100 eine Breite $s_0$ auf, während der Erregerleiter 106 eine Breite $e_0$ aufweist.

So lässt sich beispielsweise die durch den Erregerleiter 106 am Ort des Sensors erzeugte magnetische Flussdichte $B_{0x}$ basierend auf dem Abstand $h_0$ zwischen dem Hall-Sensorelement 100 und dem Erregerleiter 106, der Sensorbreite $s_0$, der Erregerleiterbreite $e_0$ und dem Strom $I_0$ durch den Erregerleiter 106 näherungsweise vorgeben.

Bei einem vertikalen Hall-Sensorelement können sich die oben erwähnten Prozesstoleranzen besonders stark auswirken, da der Abstand $h_0$ zwischen dem aktiven Bereich 104 des Hall-Sensorelements 100 und dem Erregerleiter 106 durch Prozessschwankungen bzw. Prozesstoleranzen häufig in einem Bereich von ± 40% des eigentlichen Soll-abstandes $h_0$ variieren kann. Als Folge kann die Empfindlichkeit von vertikalen Hall-Sensorelementen nur mit relativ niedriger Genauigkeit bestimmt werden.

In Fig. 7 ist nun beispielsweise die Abhängigkeit der magnetischen Flussdichte $B_{0x}$ (z.B. in µT) von der Höhe $h_0$ (in µm) des Erregerleiters 106 oberhalb des aktiven Bereichs 104 des Hall-Sensorelements 100 dargestellt. Dabei fällt die magnetische Flussdichte $B_{0x}$ proportional zu $1/h_0$ über dem Abstand $h_0$ ab. Geht man beispielsweise von einem Abstand $h_0$ von 5 µm aus, ergeben sich innerhalb eines Toleranzbereiches von beispielsweise nur etwa ±20% (± 1µm) des Abstands $h_0$ deutliche Unterschiede zu den erwarteten Werten für die magnetische Flussdichte $B_{0x}$ im aktiven Bereich 104 des Hall-Sensorelements 100. So bewirken bereits relativ geringe Änderungen $\Delta h_0$ des Abstands $h_0$ relativ starke Änderungen der in dem aktiven Bereich 104 des Hall-Sensorelements 100 erzeugten magnetischen Flussdichte $B_{0x}$.

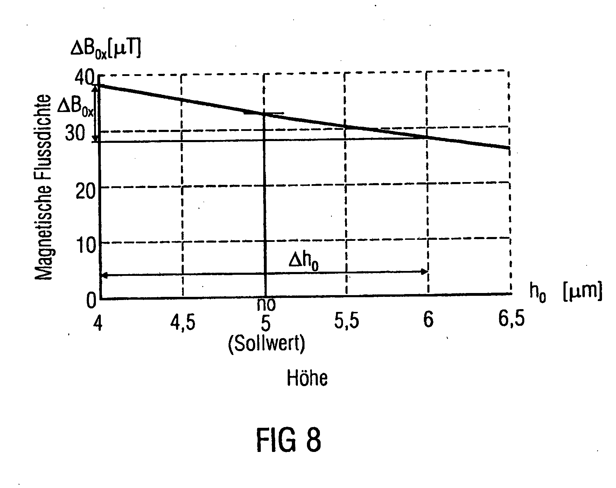

Fig. 8 zeigt nun die Änderung der magnetischen Flussdichte $\vec{B}_0$ am Ort des Sensors, d.h. im aktiven Bereich des Hall-Sensorelements 100, in Abhängigkeit von den Prozesstoleranzen $\Delta h_0$ bezüglich des Abstands $h_0$. Geht man nun wieder von einem Sollabstand $h_0$ von 5 µm aus, beträgt die bei einer vorgegebenen Kalibrierstromstärke $I_0$ erwartete magnetische Flussdichte $B_{0x}$ z.B. 33 µT. Variiert nun aber beispielsweise aufgrund der Prozesstoleranzen der Abstand $h_0$ um etwa $\Delta h_0$ = ± 20% (z.B. ± 1 µm) ergibt sich bei einem Abstand $h_0$ von 4 mm eine resultierende magnetische Flussdichte von etwa 38 µT, während sich bei einem Abstand $h_0$ von 6 mm eine resultierende magnetische Flussdichte von etwa 28 µT ergibt. Damit schwankt die resultierende magnetische Flussdichte $B_{0x}$ bereits um mehr als 25%, falls aufgrund von Prozessschwankungen der Abstand $h_0$ lediglich einem Toleranzbereich von $\Delta h_0$ = ± 20% ausgesetzt ist. Tatsächlich können häufig Prozessschwankungen von ± 40% für Schichtdicken bei Halbleiterherstellungsprozessen auftreten. Dadurch gestaltet sich eine exakte Bestimmung der Empfindlichkeit des Hall-Sensorelements 100 zumindest als sehr ungenau, wenn die Kalibrierung nicht unter Kenntnis des tatsächlichen Abstandswerts $h_0 \pm \Delta h_0$, sondern lediglich mit einem angenommenen, in der Realität aber wegen der Prozesstoleranzen $\Delta h_0$ bei der Herstellung oft nicht vollständig korrekten bzw. ungenauen Erregerleiterabstand $h_0$ durchgeführt wird.

Die wissenschaftliche Veröffentlichung "STAHL-OFFERGELD M ET AL: "Integrated sensitivity adjustment for 3D Hall sensors", SENSOR LETTERS, AMERICAN SCIENTI-FIC PUBLISHERS, US, Bd. 7, Nr. 3, 1. Juni 2009 (2009-06-01), Seiten 313-316, XP009149085, ISSN: 1546-198X, DOI: 10.1166/SL.2009.1074" bezieht sich auf eine integrierte Empfindlichkeitseinstellung für 3D-Hall-Sensoren und insbesondere auf einen 3D-Hall-Sensor mit integrierten Spulen zur Empfindlichkeits-steuerung und für Volumentests. Eine spezielle Betriebsart ermöglicht das Einstellen der Empfindlichkeiten aller drei Magnetflusskomponenten des Sensors und dies selbst während der Messungen. Indem alle orthogonalen Sensorrichtungen gleichzeitig einem Magnetfeld ausgesetzt werden, kann das "Matching" der unterschiedlichen Empfindlichkeiten selbst dann sichergestellt werden, wenn der Absolutwert des Anregungsstroms unbekannt ist.

Die DE102006034226 A1 beschreibt einen im Messbetrieb kalibrierbarer Magnetfeldsensor zur Erfassung einer ersten, zweiten und dritten räumlichen Komponente Bz, By und Bx eines Magnetfeldes in einem Referenzpunkt, wobei das Magnetfeld eine erste, zweite und dritte Messfeldkomponente BMz, BMy, BMx und eine erste, zweite und dritte Kalibrierungsfeldkomponente BKz, BKy und BKx aufweist.

Die Aufgabe der vorliegenden Erfindung besteht daher darin, einen kalibrierbare Magnetfeldsensor und ein Verfahren zum Herstellen desselben zu schaffen, wobei sich bei dem kalibrierbaren Magnetfeldsensor etwaige Herstellungsprozesstoleranzen bei einem Kalibriervorgang nur sehr geringfügig auf eine exakte Bestimmung der Empfindlichkeit der Hall-Sensoranordnung auswirken.

Diese Aufgabe wird durch den erfindungsgemäßen Magnetfeldsensor gemäß Anspruch 1 und durch das Verfahren zum Herstellen eines Magnetfeldsensors gemäß Anspruch 9 gelöst.

Vorteilhafte Weiterbildungen der Erfindung sind in den Unteransprüchen angegeben.

Der Kerngedanke der vorliegenden Erfindung besteht darin, dass eine Erregerleiteranordnung mit einem Erregerleiter oder einer Mehrzahl von Erregerleitern in einem Magnetfeldsensor bzw. einer kalibrierbaren Magnetfeldsensoranordnung seitlich versetzt zu einer Mittenposition, die sich senkrecht oberhalb bzw. unterhalb zu dem vertikalen Hall-Sensorelement befindet, angeordnet wird, wobei der Versatz bzw. laterale Abstand zu der Mittenposition so in Abhängigkeit von dem vertikalen Abstand eingestellt wird, dass herstellungsbedingte Prozessschwankungen einen deutlich geringeren Einfluss auf einen Kalibriervorgang haben, ohne dass die tatsächlich auftretenden Prozessschwankungen quantitativ bekannt sein müssen. Aufgrund des seitlichen Versatzes des Erregerleiters zu der Mittenposition hat die von dem Hall-Sensorelement erfassbare Komponente $B_{1x}$ in x-Richtung der magnetischen Flussdichte in dem aktiven Halbleiterbereich des Hall-Sensorelements in Abhängigkeit von dem vertikalen Abstand bzw. der Höhe zwischen dem Erregerleiter und dem aktiven Bereich des Hall-Sensorelements einen Verlauf, der ein lokales Maximum aufweist und damit in dem Bereich um das lokale Maximum eine sehr geringe Abhängigkeit der magnetischen Flussdichte von prozessbedingten Abstandsschwankungen zeigt. Als vertikaler Abstand bzw. als Höhe zwischen dem Erregerleiter und dem aktiven Bereich des Hall-Sensorelements wird der Abstand zwischen einer Ebene, die durch den Schwerpunkt bzw. die Schwerpunktlinie des Erregerleiters definiert ist, und einer Ebene, die durch den Schwerpunkt bzw. die Schwerpunktlinie des aktiven Bereichs des Hall-Sensorelements definiert ist, angesehen, wobei beide Ebenen parallel zueinander und zu der Halbleitersubstratoberfläche sind.

Da bei Halbleiterherstellungsprozessen laterale Abmessungen erheblich geringeren Prozessschwankungen unterliegen, kann nun der laterale Abstand bzw. seitliche Versatz des Erregerleiters zu der Mittenposition exakt so dimensioniert werden, dass sich die resultierende Kalibrierungskomponente einer von der Erregerleiteranordnung in dem aktiven Bereich des vertikalen Hall-Sensorelements erzeugten, magnetischen Flussdichte innerhalb des Toleranzbereichs für den vertikalen Abstand um weniger als 5% oder sogar 1% ändert. Dabei wird angenommen, dass beispiels-weise ein vorgegebener Kalibrierungsstrom $I_1$ in den Erregerleiter eingespeist wird.

Die in dem aktiven Bereich des vertikalen Hall-Sensorelements erzeugte vertikale Kalibrierkomponente der magnetischen Flussdichte ist somit im Wesentlichen unabhängig von den bei der Herstellung eines vertikalen Hall-Sensorelements auftretenden und häufig unvermeidbaren Prozesstoleranzen. Der erfindungsgemäße kalibrierbare Magnetfeldsensor ist nun auch ohne Kenntnis der durch Prozesstoleranzen hervorgerufenen Änderung(en) von vertikalen Abmessungen der resultierenden Schichtstruktur äußerst exakt kalibrierbar.

Bevorzugte Ausführungsbeispiele der vorliegenden Erfindung werden nachfolgend unter Bezugnahme auf die beiliegenden Zeichnungen näher erläutert. Es zeigen:

Fig. 1a-b      eine Prinzipdarstellung in einer Draufsicht und einer Schnittansicht eines kalibrierbaren Magnetfeldsensors gemäß einem Ausführungsbeispiel der vorliegenden Erfindung;

Fig. 2      einen prinzipiellen Verlauf der magnetischen Flussdichte aufgrund der seitlich versetzten Anordnung des Erregerleiters und in Abhängigkeit von dem vertikalen Abstand gemäß einem Ausführungsbeispiel der vorliegenden Erfindung;

Fig. 3        einen prinzipiellen Verlauf der magnetischen Flussdichte in einem Toleranzbereichs für den vertikalen Abstand gemäß einem Ausführungsbeispiel der vorliegenden Erfindung;

Fig. 4a-b     eine Prinzipdarstellung in einer Draufsicht und einer Schnittansicht eines kalibrierbaren Magnetfeldsensors gemäß einem weiteren Ausführungsbeispiel der vorliegenden Erfindung;

Fig.5         ein schematisches Ablaufdiagramm eines Verfahrens zur Herstellung eines kalibrierbaren Magnetfeldsensors gemäß einem weiteren Ausführungsbeispiel der vorliegenden Erfindung;

Fig. 6 a-b    eine Prinzipdarstellung in einer Draufsicht und einer Schnittansicht eines Magnetfeldsensors gemäß dem Stand der Technik;

Fig. 7        einen prinzipiellen Verlauf der magnetischen Flussdichte bei einem Magnetfeldsensor gemäß dem Stand der Technik; und

Fig. 8        einen prinzipiellen Verlauf der magnetischen Flussdichte bei einem Magnetfeldsensor in Abhängigkeit von Prozesstoleranzen dem Stand der Technik.

Bevor nachfolgend die vorliegende Erfindung im Detail anhand der Zeichnungen näher erläutert wird, wird darauf hingewiesen, dass identische, funktionsgleiche oder gleichwirkende Elemente in den Figuren mit den gleichen Bezugszeichen versehen sind, so dass die in unterschiedlichen Ausführungsbeispielen dargestellte Beschreibung dieser Elemente untereinander austauschbar ist bzw. aufeinander angewendet werden kann.

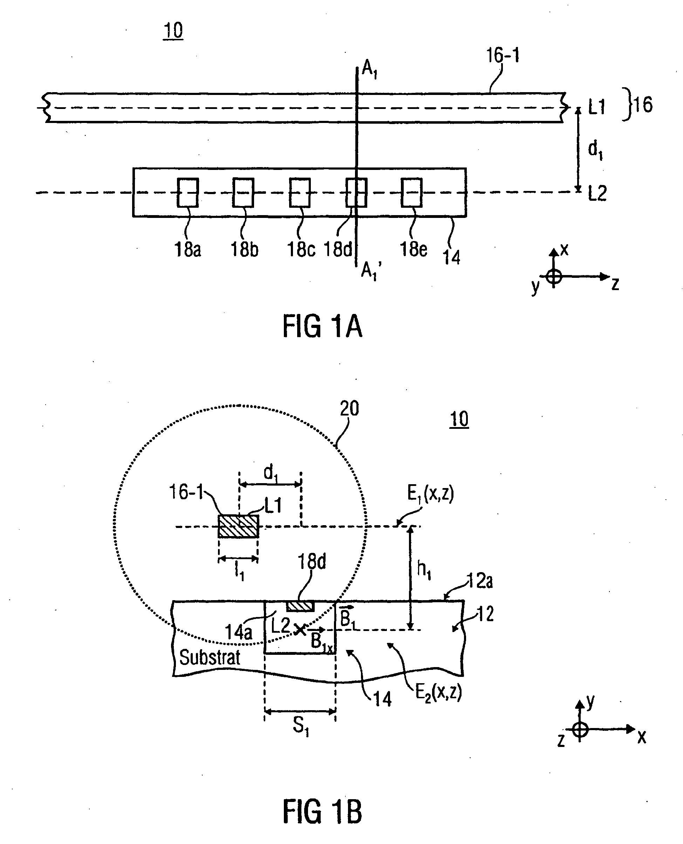

Im Folgenden wird nun anhand von Fig. 1a-b ein erstes Ausführungsbeispiel für einen kalibrierbaren Magnetfeldsensor 10 gemäß der vorliegenden Erfindung beschrieben.

Fig. 1a-b zeigen nun in einer schematischen Schnittdarstellung den kalibrierbaren Magnetfeldsensor 10 mit dem in einem Halbleitersubstrat 12 angeordneten vertikalen Hall-Sensorelement 14 und die zu dem Hall-Sensorelement 14 beabstandeten Erregerleiteranordnung 16. Bei dem in Fig. 1a-b dargestellten Ausführungsbeispiel weist die Erregerleiteranordnung 16 einen Erregerleiter 16-1 auf. Wie ferner in den Figuren 1a-b dargestellt ist, weist beispielsweise der aktive Bereich 14a des Hall-Sensorelements 14 eine Breite s auf, während der Erregerleiter 16-1 eine Breite $e_1$ aufweist. Das vertikale Hall-Sensorelement 14 weist in Fig. 1a beispielsweise fünf Kontaktbereiche 18a-e an der Hauptoberfläche 12a des Halbleitersubstrats 12 entlang des aktiven Halbleiterbereichs 14 auf. Das vertikale Hall-Sensorelement 14 kann aber auch eine andere Anzahl und Anordnung von Kontaktbereichen aufweisen.

Wie nun in Fig. 1b entlang der Schnittlinie $A_1A_1$' von Fig. 1a dargestellt ist, ist bei dem erfindungsgemäßen kalibrierbaren Magnetfeldsensor 10 der Erregerleiter 16-1 in einer Erregerleiterebene $E_1$ (parallel zur x-z-Ebene), die beispielsweise durch einen geometrischen Schwerpunkt bzw. eine Schwerpunktlinie $L_1$ des Erregerleiters 16-1 verläuft, parallel zu der Substratoberfläche 12a in einem vertikalen Abstand bzw. einer Höhe $h_1$ von einer Ebene $E_2$ (parallel zur x-z-Ebene), die durch einen Schwerpunkt bzw. eine Schwerpunktlinie $L_2$ des aktiven Bereichs 14a des Hall-Sensorelements 14 verläuft, beabstandet. Der vertikale Abstand $h_1$ ist beispielsweise bei einem Halbleiterherstellungsprozess Prozesstoleranzen bzw. Prozessschwankungen $\Delta h_1$ ausgesetzt. Der Erregerleiter 16-1 ist nun ferner in einem lateralen Abstand $d_1$ als Versatz zu einer Mittenposition, die sich bezüglich der Substratoberfläche 12a senkrecht oberhalb (oder optional auch unterhalb) des vertikalen Hall-Sensorelements 14 befindet, angeordnet.

Somit können sich aufgrund der Prozessschwankungen Änderungen für den vertikalen Abstand $h_1$ zwischen der Ebene $E_1$, die durch den Schwerpunkt bzw. die Schwerpunktlinie $L_1$ des Erregerleiters 16-1 verläuft, und der Ebene $E_2$, die durch den Schwerpunkt bzw. die Schwerpunktlinie $L_2$ des aktiven Bereichs 14a des Hall-Sensorelements 14 verläuft, ergeben, wobei beide Ebenen $E_1$, $E_2$ parallel zueinander und zu der Halbleitersubstratoberfläche 12a sind.

Auf der Halbleitersubstratoberfläche 12a können beispielsweise mehrere, unterschiedliche Prozesslagen gebildet sein, wie z.B. eine Metall-1-Prozesslage für die Kontaktanschlüsse 18a-d zu dem vertikalen Hall-Sensorelement 14 sowie eine Metall-2-Prozesslage, in der z.B. die Erregerleiteranordnung 16 mit dem Erregerleiter 16-1 ausgebildet sein kann. Natürlich können beispielsweise noch eine oder mehrere weitere Metall-Prozesslagen vorgesehen sein, um die Kontaktanschlüsse 18a-d zu dem vertikalen Hall-Sensorelement 14 sowie die Erregerleiteranordnung 16 mit dem Erregerleiter 16-1 auszubilden. Der Erregerleiter 16-1 kann als Leiterbahn eines Halbleiterbauelements ausgebildet sein. Zwischen einzelnen Metallisierungsschichten, z.B. Metall-1 und Metall-2 etc., bzw. auf der Halbleitersubstratoberfläche 12a können Isolationsschichten, z.B. aus einem Oxid- oder Nitrid-Material, angeordnet sein, die in Fig. 1a-b nicht explizit dargestellt sind.

Wird nun ein Strom $I_1$ (mit einer Stromstärke von z.B. 1 mA) in den Erregerleiter 16-1 eingeprägt und fließt z.B. in einer Richtung aus der Zeichenebene von Fig. 1b heraus (z-Richtung), so wird durch den Stromfluss eine magnetische Flussdichte $\vec{B}_1$ am Ort des Sensors, d.h. im Schwerpunkt des aktiven Bereichs 14a des vertikalen Hall-Sensorelements 14, hervorgerufen. Die magnetischen Feldlinien 20 sind in diesem Ausführungsbeispiel radial um den Erregerleiter 16-1 in der x-y-Ebene angeordnet, wobei das Hall-Sensorelement eine Magnetfeldkomponente $B_{1x}$ in x-Richtung detektieren kann. Bei der magnetischen Flussdichte $\vec{B}_1$ handelt es sich um einen Vektor, der beispielsweise in einem kartesischen Koordinatensystem mit linear unabhängigen Ortsvektoren x, y, z entsprechenden Magnetfeldkomponenten $B_{1x}$, $B_{1y}$ und $B_{1z}$ darstellbar ist.

Die in Fig. 1a-b dargestellte Anordnung des Erregerleiters 16-1 bezüglich des aktiven Bereichs 14a des Hall-Sensorelements 14 mit dem lateralen Versatz $d_1$ des Erregerleiters 16-1 zu der Mittenposition ergibt nun (näherungsweise) eine magnetische Flussdichte $B_{1x}$ in Empfindlichkeitsrichtung (in x-Richtung von Fig. 1a-b) des vertikalen Hall-Sensorelements 14 gemäß folgender Gleichung:

$$B_{1x} = \frac{\int_{-e/2}^{+e/2} \int_{-s/2}^{+s/2} \frac{\mu}{2\pi} \cdot \frac{h_1}{(x1 - x2 + d_1)^2 + h_1^2} \cdot I_1 \; dx1 \; dx2}{s \cdot e_1} \; ; \tag{1}$$

Dabei stellt $d_1$ den seitlichen Versatz des Erregerleiters 16-1 bezüglich der Mittenposition dar, während der aktive Bereich 14a des vertikalen Hall-Sensorelements 14 eine effektive Breite s aufweist, und der Erregerleiter 16 eine Breite $e_1$ (in der Ebene $E_1$) aufweist.

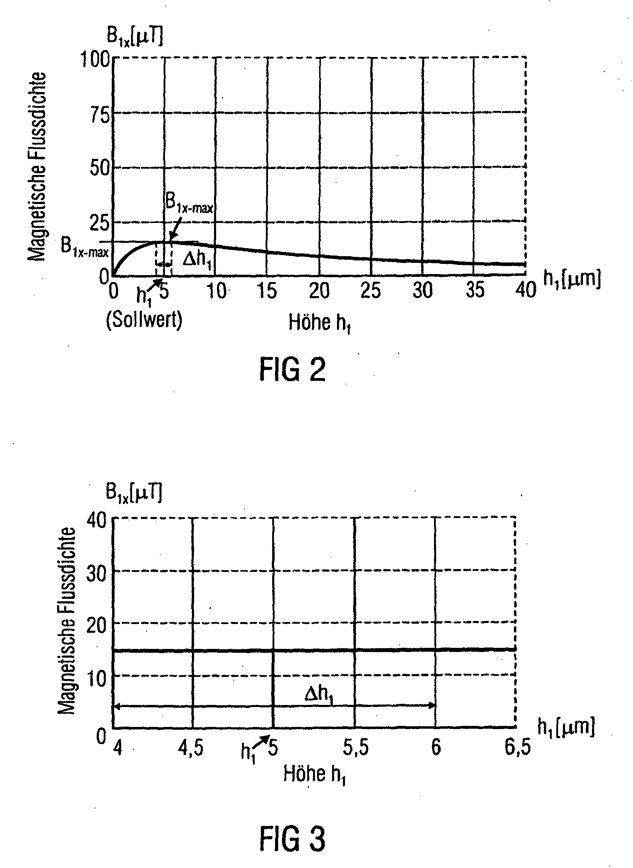

Durch den erfindungsgemäß vorgenommenen seitlichen Versatz $d_1$ des Erregerleiters 16-1 in der Erregerleiterebene $E_1$ zu der Mittenposition ergibt sich ein resultierender Verlauf der magnetischen Flussdichte $B_{1x}$ in Abhängigkeit des vertikalen Abstandes $h_1$ und bei einer Stromstärke $I_1$ von z.B. 1 mA, wie dies anhand von Fig. 2 dargestellt ist. Aus Fig. 2 wird ersichtlich, dass ab einem Wert für den vertikalen Abstand von $h_1 = 0$ [μm] und bei einer Stromstärke $I_1$ von z.B. 1 mA die magnetische Flussdichte $B_{1x}$ von einem Wert nahe 0 [μT] ansteigt. Ein vertikaler Abstand $h_1 = 0$ bedeutet, dass sich der Erregerleiter 16 und der aktive Bereich des Hall-Sensorelements 14 parallel in einer Ebene zueinander befinden würden. In diesem Fall würde somit die resultierende Komponente $B_{1y}$ der magnetischen Flussdichte $\vec{B}_1$ das vertikale Hall-Sensorelement 14 senkrecht zu dessen Empfindlichkeitsrichtung durchdringen und i. W. kein Ausgangssignal erzeugen. Mit einem sich erhöhenden Wert für den vertikalen Abstand $h_1$ steigt nun die resultierende Komponente $B_{1x}$ der magnetischen Flussdichte $\vec{B}_1$ die von dem vertikalen Hall-Sensorelement 14 erfassbar ist, bis zu einem Maximalwert $\vec{B}_{1xmax}$ an und fällt dann relativ langsam nach einem Plateaubereich bzw. dem lokalem Maximum $\vec{B}_{1xmax}$ mit steigenden Werten für den vertikalen Abstand $h_1$ wieder ab.

Die obigen Werte für die gewählte Stromstärke $I_1$ und den vertikalen Abstand $h_1$ sind nur als beispielhaft anzusehen, um den in Fig. 2 und 3 qualitativ dargestellten Verlauf der magnetischen Flussdichte $B_{1x}(h_1)$ in Abhängigkeit des vertikalen Abstandes $h_1$ zu erhalten.

Erfindungsgemäß wird nun unter Kenntnis des Verlaufs der resultierenden Magnetfeldkomponente $B_{1x}$ der in dem aktiven Bereich des Hall-Sensorelements erzeugten Flussdichte $\vec{B}_1$ der laterale Abstand $d_1$ des Erregerleiters 16 zu der Mittenposition so dimensioniert bzw. eingestellt, dass bei einem vorgegebenen vertikalen Abstand $h_1$ (z.B. $h_1 = 5$ μm), der beispielsweise Prozesstoleranzen ausgesetzt ist und innerhalb eines Toleranzbereichs von $\Delta h_1$ (z.B. $\pm 1$ μm) schwanken kann, der Verlauf der Komponente $B_{1x}$ der magnetischen Flussdichte $\vec{B}_1$ innerhalb des für den vertikalen Abstand $h_1 \pm \Delta h_1$ zu erwartenden Toleranzbereichs einen möglichst hohen aber auch einen über diesen Toleranzbereich möglichst linearen Verlauf aufweist. Dies wird nun erfindungsgemäß erreicht, indem der Wert für den lateralen Abstand $d_1$ in Abhängigkeit des vertikalen (Soll-)Abstands $h_0$ so gewählt wird, dass der Verlauf der Komponente $B_{1x}$ der magnetischen Flussdichte in dem Hall-Sensorelement 14 den (lokalen) Maximalwert mit einem möglichst linearen Bereich für den Wert des vertikalen Abstands $h_1$ und dessen Toleranzbereich $h_1 \pm \Delta h_1$ aufweist, d.h. in einem Bereich um das lokale Maximum $B_{1x\text{-}max}$ von Fig. 2 liegt.

Wie nun in Fig. 3 dargestellt ist, die eine Ausschnittsvergrößerung des Verlaufs der Komponente $B_{1x}$ im Bereich des lokalen Maximums $B_{1x\text{-}max}$ darstellt, variiert die durch den versetzt platzierten Erregerleiter 16-1 erzeugte Komponente $B_{1x}$ der magnetischen Flussdichte $\vec{B}_1$ nur noch um etwa $\pm 1\%$ über den Bereich für Prozesstoleranzen $h_1 \pm \Delta h_1$ für den vertikalen Abstand $h_1$. Wird beispielsweise angenommen, dass der vertikale (Soll-)Abstand $h_1 = 5$ μm beträgt, und Prozesstoleranzen von $\pm 20\%$ auftreten können, kann der tatsächliche vertikale Abstand $h_1$ Werte in einem Bereich von $h_1 = 4$ bis 6 μm aufweisen. Diese Prozesstoleranzen wirken sich aber nur äußerst gering bei einer Empfindlichkeitsmessung bzw. einem Kalibriervorgang des vertikalen Hall-Sensorelements 14 aus, wie dies aus dem nahezu linearen Verlauf der Magnetfeldkomponente $B_{1x}$ über dem vertikalen Abstand $h_1$ von Fig. 3 deutlich wird.

Da der Maximalwert $B_{1x\text{-}max}$ des Verlaufs der Komponente $B_{1x}$ der magnetischen Flussdichte $\vec{B}_1$ in dem aktiven Bereich 14a des Hall-Sensorelements 14 von dem seitlichen Versatz $d_1$ des Erregerleiters 16-1 abhängt, kann der laterale Abstand $d_1$ gezielt so dimensioniert werden, dass der Einfluss von Prozesstoleranzen auf die Empfindlichkeitsmessung bzw. den Kalibriervorgang des Hall-Sensorelements 14 deutlich reduziert ist. Erfindungsgemäß ist beispielsweise der laterale Abstand $d_1$ gezielt so einstellbar, dass sich eine Kalibrierkomponente $B_{1x}$ bei einem vorgegebenen Stromfluss bzw. Kalibrierstrom $I_1$ und einer entsprechend in dem vertikalen Hall-Sensorelement 14 erzeugten, magnetischen Flussdichte $\vec{B}_1$ bzw. deren x-Komponente $B_{1x}$ in dem Toleranzbereich $\Delta h_1$ für den vertikalen Abstand $h_1$ um weniger als 5% oder 1% ändert.

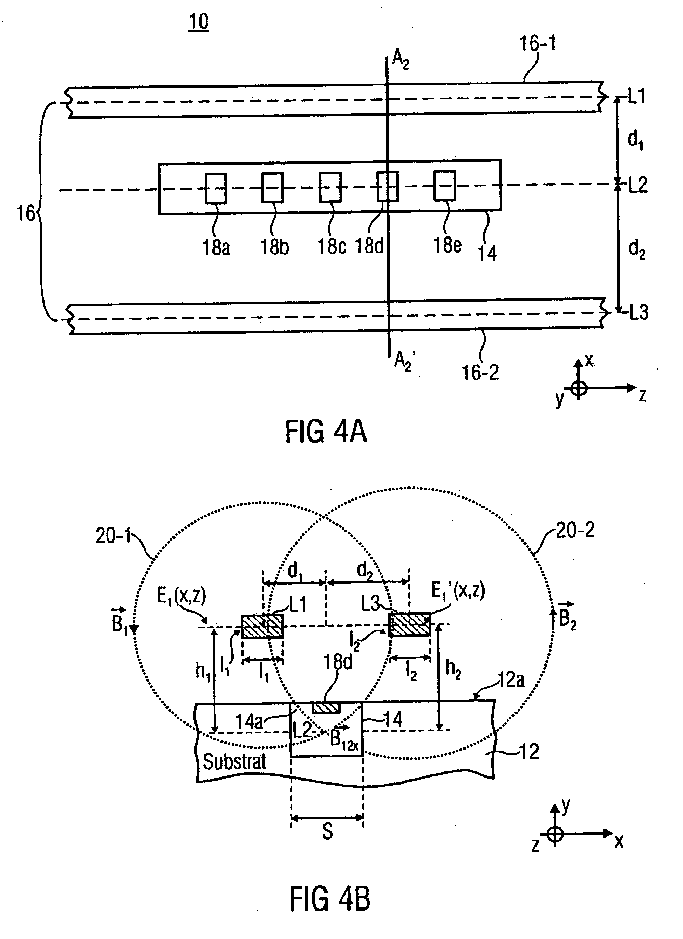

Im Folgenden wird nun Bezug nehmend auf Fig. 4a-b ein weiteres Ausführungsbeispiel des erfindungsgemäßen kalibrierbaren Magnetfeldsensors 10 beschrieben. Wie in Fig. 4a-b dargestellt ist, weist die Erregerleiteranordnung 16 zusätzlich zu dem ersten Erregerleiter 16-1 einen weiteren, zweiten Erregerleiter 16-2 auf. Der zweite Erregerleiter 16-2 ist wiederum in einer Erregerleiterebene $E'_1$ angeordnet, die parallel zu der Substratoberfläche 12a in einem vertikalen Abstand $h_2$, die beispielsweise wiederum aufgrund von Prozessschwankungen einem Toleranzbereich $\Delta h_2$ ausgesetzt ist, von dem vertikalen Hall-Sensorelement 14 beabstandet. Ferner weist der zweite Erregerleiter 22 einen lateralen Abstand $d_2$ als Versatz zu der Mittenposition, die sich bezüglich der Substratoberfläche 12a senkrecht oberhalb zu dem vertikalen Hall-Sensorelement 14 befindet, auf.

Wie in Fig. 4b schematisch dargestellt ist, ist das Sensorelement 14 in dem Halbleitersubstrat 12 ausgebildet, wobei auf der Halbleitersubstratoberfläche 12a mehrere Prozesslagen, z.B. eine Metall-1-Prozesslage (nicht gezeigt in Fig. 4b) für etwaige Kontaktanschlüsse zu dem vertikalen Hall-Sensorelement 14 sowie eine Metall-2-Prozesslage, vorgesehen sind, in der der erste und der zweite Erregerleiter 16-1, 16-2 ausgebildet sind. Natürlich können beispielsweise noch eine oder mehrere weitere Metall-Prozesslagen vorgesehen sein, um die Kontaktanschlüsse 18a-d zu dem vertikalen Hall-Sensorelement 14 sowie die Erregerleiteranordnung 16 mit den Erregerleitern 16-1, 16-2 etc. auszubilden. Der erste und zweite Erregerleiter 16-1, 16-2 können als integrierte Leiterbahnen oberhalb des Halbleitersubstrats 12 angeordnet sein, wobei zwischen den einzelnen Metallisierungsschichten Metall-1 und Metall-2 etc. bzw. der Halbleitersubstratoberfläche 12a isolierende Schichten (nicht gezeigt in Fig. 4) angeordnet sein können.

Wie ferner in den Figuren 4a-b dargestellt ist, weist beispielsweise der aktive Bereich 14a des Hall-Sensorelements 14 eine Breite s auf, während der Erregerleiter 16-1 eine Breite $e_1$ und der Erregerleiter 16-2 eine Breite $e_2$ aufweist. Das vertikale Hall-Sensorelement 14 weist in Fig. 4a beispielsweise wieder fünf Kontaktbereiche 18a-e an der Hauptoberfläche 12a des Halbleitersubstrats 12 entlang des aktiven Halbleiterbereichs 14 auf. Das vertikale Hall-Sensorelement 14 kann aber auch eine andere Anzahl und Anordnung von Kontaktbereichen aufweisen.

Wie nun in Fig. 4b entlang der Schnittlinie $A_2A_2'$ von Fig. 4a dargestellt ist, ist bei dem erfindungsgemäßen kalibrierbaren Magnetfeldsensor 10 der erste Erregerleiter 16-1 in einer Erregerleiterebene $E_1$ (parallel zur x-z-Ebene), die beispielsweise durch einen geometrischen Schwerpunkt bzw. eine Schwerpunktlinie $L_1$ des Erregerleiters 16-1 verläuft, und der zweite Erregerleiter 16-2 in einer Erregerleiterebene $E_1'$ (auch parallel zur x-z-Ebene), die beispielsweise durch einen geometrischen Schwerpunkt bzw. eine Schwerpunktlinie $L_3$ des Erregerleiters 16-2 verläuft, parallel zu der Substratoberfläche 12a in einem vertikalen Abstand oder einer Höhe $h_1$ bzw. $h_2$ von einer Ebene $E_2$ (parallel zur x-z-Ebene), die durch einen Schwerpunkt bzw. eine Schwerpunktlinie $L_2$ des aktiven Bereichs 14a des Hall-Sensorelements 14 verläuft, beabstandet. Der vertikale Abstand $h_1$ und $h_2$ ist beispielsweise bei einem Halbleiterherstellungsprozess Prozesstoleranzen bzw. Prozessschwankungen $\Delta h_1$ bzw. $\Delta h_2$ ausgesetzt. Der Erregerleiter 16-1 ist nun ferner in einem lateralen Abstand $d_1$ als Versatz zu einer Mittenposition, die sich bezüglich der Substratoberfläche 12a senkrecht oberhalb (oder optional auch unterhalb) des vertikalen Hall-Sensorelements 14 befindet, angeordnet.

Wie in Fig. 4a-b dargestellt ist, sind der erste und der zweite Erregerleiter 16-1, 16-2 in derselben Erregerleiterebene $E_1 = E'_1$ angeordnet, so dass für den vertikalen Abstand $h_1 = h_2$ gilt. Dies trifft beispielsweise zu, wenn die beiden Erregerleiter 16-1, 16-2 der Erregerleiteranordnung 16 beim Herstellungsprozess in der gleichen Metall-Prozesslage erzeugt werden, und somit auch den gleichen Prozesstoleranzen hinsichtlich des vertikalen Abstands $h_1$ und $h_2$ ausgesetzt sind. Lediglich optional können der vertikale Abstand $h_1$ für den ersten Erregerleiter 16-1 und der vertikale Abstand $h_2$ für den zweiten Erregerleiter 16-2 unterschiedlich gewählt werden.

Wird nun in dem ersten Erregerleiter 16-1 ein erster Strom $I_1$ und in dem zweiten Erregerleiter 16-2 ein zweiter Strom $I_2$ (z.B. in der gleichen Richtung) eingeprägt, so wird durch den Stromfluss $I_1$ bzw. $I_2$ in dem jeweiligen Erregerleiter 16-1 und 16-2 eine magnetische Flussdichte $\vec{B}_1$ und $\vec{B}_2$ im aktiven Bereich 14a des Hall-Sensorelements 14 hervorgerufen, die sich zu einer resultierenden magnetischen Flussdichte $\vec{B}_{12}$ am Ort des Sensors überlagern. Die magnetischen Feldlinien 20-1, 20-2 sind in diesem Ausführungsbeispiel radial um den jeweiligen Erregerleiter 16-1, 16-2 in der x-y-Ebene angeordnet, wobei bei dem vertikalen Hall-Sensorelement 14 eine resultierende Magnetfeldkomponente $B_{12x}$ in x-Richtung detektiert werden kann.

Werden nun bei einem kalibrierbaren Magnetfeldsensor der erste und zweite Erregerleiter 16-1, 16-2 mit einem unterschiedlichen Versatz $d_1$ bzw. $d_2$ in der Erregerleiterebene $E_1$ (falls z.B. $h_1 = h_2$) versetzt zu einer Mittenposition platziert, so liegen die jeweiligen Maxima für die Komponente $B_{1x}$ und $B_{2x}$ der von dem ersten und zweiten Erregerleiter 16-1, 16-2 erzeugten magnetischen Flussdichte $B_{12x}$ im aktiven Bereich 14a des Hall-Sensorelements 14 in Abhängigkeit von dem jeweiligen vertikalen Abstand $h_1$ und/oder $h_2$ an unterschiedlichen Stellen, bezogen auf den Verlauf der Komponente $B_{12x}$ der magnetischen Flussdichte dargestellt über den vertikalen Abstand $h_1$ und $h_2$. Durch eine gezielte Überlagerung der Magnetfelder, die jeweils von einem vorgegebenen Kalibrierstrom $I_1$, $I_2$ in dem ersten bzw. zweiten Erregerleiter 16-1, 16-2 erzeugt werden, kann so der Einfluss von Prozesstoleranzen auf den vertikalen Abstand $h_1$, $h_2$ der Erregerleiteranordnung 16 von dem aktiven Bereich 14a des vertikalen Hall-Sensorelements 14 noch weiter reduziert werden, da durch das gezielte Einstellen des seitlichen Versatzes in Form des lateralen Abstandes $d_1$ und $d_2$ für den ersten und zweiten Erregerleiter 16-1, 16-2 eine weitere Linearisierung bezüglich der resultierenden Komponente $B_{12x}$ der Kombination der magnetischen Flussdichten $\vec{B}_1$ und $\vec{B}_2$ im aktiven Bereich 14a des Hall-Sensorelements 14 erreicht werden kann.

Die durch den ersten und zweiten Erregerleiter 16-1, 16-2 erzeugte Komponente $B_{12x}$ der resultierenden magnetischen Flussdichte $\vec{B}_{12}$ lässt sich mit folgender Gleichung näherungsweise darstellen:

$$B_{12x} = \frac{\displaystyle\int_{-e_1/2}^{+e_1/2}\int_{-s/2}^{+s/2} \frac{\mu}{2\pi} \cdot \frac{h_1}{(x1-x2+d_1)^2+h_1^2} \cdot I_1 \; dx1 \; dx2}{s \cdot e_1} +$$

$$\frac{\displaystyle\int_{-e_2/2}^{+e_2/2}\int_{-s/2}^{+s/2} \frac{\mu}{2\pi} \cdot \frac{h_2}{(x1-x2+d_2)^2+h_2^2} \cdot I_2 \; dx1 \; dx2}{s \cdot e_2} \; ; \qquad (2)$$

Wird nun beispielsweise die resultierende Komponente $B_{12x}$ der magnetischen Flussdichte in dem aktiven Bereich 14a des vertikalen Hall-Sensorelements 14 anhand von Gleichung 2 berechnet, wobei der laterale Abstand bzw. Versatz d1 und d2 als Variablen in dem Ergebnis beibehalten werden, kann beispielsweise durch eine algebraische Auswertung der daraus resultierenden Funktion in Abhängigkeit der lateralen Abstände d1 und d2 ein lokaler Maximalwert für die resultierende Komponente $B_x$ der magnetischen Flussdichte berechnet bzw. bestimmt werden.

Somit lassen sich durch die gezielte Einstellung des lateralen Abstands d1 und d2 für den ersten bzw. zweiten Erregerleiter 16-1, 16-2 und eine daraus resultierende weitere Linearisierung des Verlaufs für die Komponente $B_{12x}$ in einem Bereich realisieren, in dem der vertikale Abstand $h_1$, $h_2$ den Prozesstoleranzen $\Delta h_1$, $\Delta h_2$ ausgesetzt ist.

Aus den obigen Ausführungen sollte deutlich werden, dass die Erregerleiteranordnung 16 auch mehr als zwei Erregerleiter (nicht gezeigt in den Figuren) aufweisen kann, deren Magnetfelder so kombiniert werden können, um eine weitere Linearisierung der erfassbaren Komponente $B_x$ in dem aktiven Halbleiterbereich des Hall-Sensorelements 14 zu erhalten. Die weiteren Erregerleiter sind in einer oder mehreren weiteren Erregerleiterebene(n), die parallel zu der Substratoberfläche (12a) in einem vertikalen Abstand $h_n$, der einen Herstellungsprozess-bedingten Toleranzbereich $\Delta h_n$ aufweist, von dem vertikalen Hall-Sensorelement (14) beabstandet, und weisen ferner jeweils einen lateralen Abstand $d_n$ als Versatz zu der Mittenposition auf, wobei der laterale Abstand $d_n$ jeweils so dimensioniert ist, dass sich eine resultierende Kalibrierkomponente $B_{2n}$ einer von der Erregerleiteranordnung in dem vertikalen Hall-Sensorelement erzeugten, magnetischen Flussdichte innerhalb des jeweiligen Toleranzbereiches $\Delta h_n$ für den jeweiligen vertikalen Abstand $h_n$ um weniger als 5% ändert.

Bezüglich der obigen Ausführungen wird ferner darauf hingewiesen, dass die Erregerleiteranordnung nicht nur integrierte Leiter bzw. Erregerleiter aufweisen kann, sondern dass die obigen Ausführungen gleichermaßen auf diskrete Leiteranordnungen, die versetzt oberhalb des aktiven Bereichs des Hall-Sensorelements angeordnet sind, angewendet werden können.

Zusammenfassend kann also festgestellt werden, dass durch die geeignete Einstellung eines lateralen Versatzes eines Erregerleiter oder einer Mehrzahl von Erregerleitern zu einer Mittenposition, die sich oberhalb (oder optional unterhalb) des aktiven Bereichs des Hall-Sensorelements befindet, ein resultierender Verlauf der von dem Hall-Sensorelement erfassbaren Komponente der magnetischen Flussdichte erhalten werden kann, der innerhalb des Toleranzbereichs für den vertikalen Abstand $h_1$ bzw. $h_2$ äußerst linear ist und möglichst einen (lokalen) Maximalwert aufweist, so dass sich bei einem Kalibriervorgang etwaige Prozesstoleranzen bezüglich des vertikalen Abstands $h_1$, $h_2$ im Wesentlichen nicht auf die in dem aktiven Bereich des Hall-Sensorelements erzeugten Komponente der magnetischen Flussdichte auswirken.

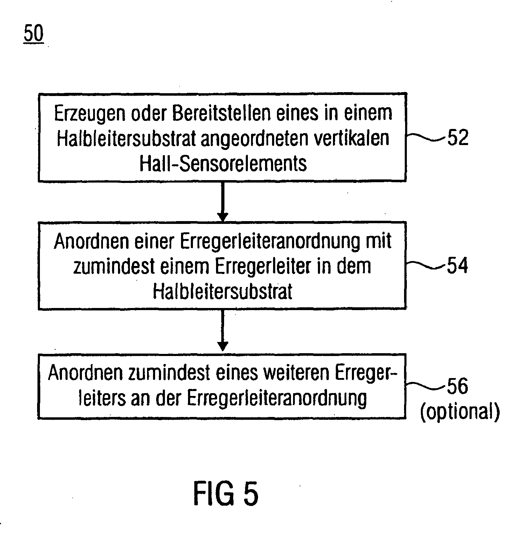

Im Folgenden wird nun anhand von Fig. 5 ein Ausführungsbeispiel in Form eines Ablaufdiagramms für ein prinzipielles Verfahren 50 zum Herstellen eines kalibrierbaren Magnetfeldsensors gemäß der vorliegenden Erfindung beschrieben.

Zunächst wird bei Schritt 52 in einem Halbleitersubstrat ein vertikales Hall-Sensorelement angeordnet bzw. ein in einem Halbleitersubstrat angeordnetes vertikales Hall-Sensorelement bereitgestellt. Daraufhin wird bei Schritt 54 eine Erregerleiteranordnung mit zumindest einem Erregerleiter oberhalb (bzw. unterhalb) zu dem vertikalen Hall-Sensorelement angeordnet, wobei der Erregerleiter 16-1 in einer Erregerleiterebene $E_1$ angeordnet wird, die parallel zu der Substratoberfläche 12a in einem vertikalen Abstand $h_1$, der einen Herstellungsprozess-bedingten Toleranzbereich $\Delta h_1$ aufweist, von dem vertikalen Hall-Sensorelement 14 beabstandet wird, und ferner einen lateralen Abstand $d_1$ als Versatz zu einer Mittenposition, die sich bezüglich der Substratoberfläche 12a senkrecht zu dem vertikalen Hall-Sensorelement 14 befindet, aufweist, und wobei der laterale Abstand $d_1$ so dimensioniert wird, dass sich eine Kalibrierkomponente $B_{1x}$ einer von der Erregerleiteranordnung 16 in dem vertikalen Hall-Sensorelement 14 erzeugten, magnetischen Flussdichte $B_1$ innerhalb des Toleranzbereiches $\Delta h_1$ für den vertikalen Abstand $h_1$ um weniger als 5% ändert.

Optional wird bei einem Schritt 56 zumindest ein weiterer Erregerleiter 16-2 an der Erregerleiteranordnung 16 angeordnet, wobei der weitere Erregerleiter 16-2 in einer weiteren Erregerleiterebene $E_1$', die parallel zu der Substratoberfläche 12a in einem vertikalen Abstand $h_2$, der einen Herstellungsprozess-bedingten Toleranzbereich $\Delta h_2$ aufweist, von dem vertikalen Hall-Sensorelement 14 beabstandet angeordnet wird, und ferner einen lateralen Abstand $d_2$ als Versatz zu der Mittenposition aufweist, und wobei der laterale Abstand $d_2$ so dimensioniert wird, dass sich eine resultierende Kalibrierkomponente $B_{2x}$ einer von der Erregerleiteranordnung in dem vertikalen Hall-Sensorelement erzeugten, magnetischen Flussdichte innerhalb des Toleranzbereiches $\Delta h_1$ für den vertikalen Abstand $h_1$ und/oder innerhalb des Toleranzbereichs $\Delta h_2$ für den vertikalen Abstand $h_2$ um weniger als 5% ändert

In der vorhergehenden Beschreibung des erfindungsgemäßen kalibrierbaren Magnetfeldsensors und dessen Herstellungsverfahrens wurde der kalibrierbare Magnetfeldsensor mit einem in dem Halbleitersubstrat angeordneten vertikalen Hall-Sensorelement dargestellt. Es sollte aber deutlich werden, dass der kalibrierbare Magnetfeldsensor auch eine Mehrzahl von vertikalen Hall-Sensorelementen und eine entsprechende Erregerleiteranordnung mit einem Erregerleiter oder einer Mehrzahl von Erregerleitern aufweisen kann. Dabei ist die im vorhergehenden beschriebene, erfindungsgemäße Ausgestaltung der für einen Kalibriervorgang vorgesehenen Erregerleiteranordnung und deren Anordnung relativ zu einem vertikalen Hall-Sensorelement jeweils auch auf die einzelnen vertikalen Hall-Sensorelemente eines solchen kalibrierbaren Magnetfeldsensors, der mehrere vertikale Hall-Sensoreinzelelemente aufweist, entsprechend anwendbar.

Obwohl manche Aspekte im Zusammenhang mit einer Vorrichtung beschrieben wurden, versteht es sich, dass diese Aspekte auch eine Beschreibung des entsprechenden Verfahrens darstellen, so dass ein Element einer Vorrichtung oder dessen Ausgestaltung auch als ein entsprechender Verfahrensschritt oder als ein Merkmal eines Verfahrensschrittes zu verstehen ist. Analog dazu stellen Aspekte, die im Zusammenhang mit einem oder als ein Verfahrensschritt beschrieben wurden, auch eine Beschreibung eines entsprechenden Elements, Details oder Merkmals einer entsprechenden Vorrichtung dar.

Gemäß einem Ausführungsbeispiel umfasst der Magnetfeldsensor 10 beispielsweise ein in einem Halbleitersubstrat 12, in dessen Oberfläche eine x- und eine z-Richtung verläuft und zu dessen Oberfläche vertikal eine y-Richtung verläuft, angeordnetes vertikales Hall-Sensorelement 14, dessen Kontakte entlang der z-Richtung angeordnet sind, und eine Erregerleiteranordnung 16 mit zumindest einem Erregerleiter 16-1. Der Erregerleiter 16-1 ist beispielsweise in einer Erregerleiterebene $E_1$ angeordnet, die parallel zu der Substratoberfläche 12a in einem vertikalen Abstand, der innerhalb eines Toleranzbereichs $\Delta h_1$ = 20% gleich einem Abstand $h_1$ ist, von dem vertikalen Hall-Sensorelement 14 beabstandet ist, und ferner einen lateralen Abstand in x-Richtung $d_1$ von dem vertikalen Hall-Sensorelement 14 aufweist. Der laterale Abstand $d_1$ ist beispielsweise so dimensioniert, dass sich eine Kalibrierkomponente $B_{1x}$ in x-Richtung einer von der Erregerleiteranordnung 16 in dem vertikalen Hall-Sensorelement 14 bei einem vorgegebenen Kalibrierungsstrom erzeugten, magnetischen Flussdichte $B_1$ innerhalb des Toleranzbereiches $\Delta h_1$ für den vertikalen Abstand $h_1$ um weniger als 5% ändern würde, wobei die Abstände jeweils von der geometrischen Schwerpunktlinie des Erregerleiters und des aktiven Bereichs des Hall-Sensorelements aus bestimmt sind.

Dabei ist der laterale Abstand $d_1$ beispielsweise so gewählt, dass der Verlauf der Kalibrierungskomponente $B_{1x}$ in Abhängigkeit von einem vertikalen Abstand h bei einer Kalibrierungsstromstärke $I_1$ der von dem Erregerleiter in dem vertikalen Hall-Sensorelement erzeugten, magnetischen Flussdichte, die durch folgende Gleichung angenommen ist:

$$B_{1x} = \frac{\displaystyle\int_{-e_1/2}^{+e_1/2}\int_{-s/2}^{+s/2} \frac{\mu}{2\pi} \cdot \frac{h_y}{\left(x1-x2+d_1\right)^2 + h_y^{\,2}} \cdot I_1 \; dx1 \; dx2}{s \cdot e_1}$$

wobei der Erregerleiter 16-1 eine Breite $e_1$ und der aktive Halbleiterbereich 14a des vertikalen Hall-Sensorelements 14 eine Breite s aufweist, und bei $h=h_1$ einen lokalen Maximalwert annimmt.

Die Erregerleiteranordnung 16-1 weist beispielsweise ferner einen weiteren Erregerleiter 16-2 auf, wobei der weitere Erregerleiter 16-2 in einer weiteren Erregerleiterebene $E_1'$, die parallel zu der Substratoberfläche 12a in einem vertikalen Abstand von dem vertikalen Hall-Sensorelement 14 beabstandet ist, und ferner einen lateralen Abstand $d_2$ von dem vertikalen Hall-Sensorelement in x-Richtung aufweist.

Der Erregerleiter 16-1 ist beispielsweise als eine integrierte oder diskrete Leiterstruktur ausgebildet, wobei der weitere Erregerleiter 16-2 als eine integrierte oder diskrete Leiterstruktur ausgebildet ist.

Die Erregerleiteranordnung 16 weist beispielsweise eine Mehrzahl von weiteren Erregerleitern auf, wobei die weiteren Erregerleiter in einer oder mehreren weiteren Erregerleiterebene(n), die parallel zu der Substratoberfläche 12a jeweils in einem vertikalen Abstand von dem vertikalen Hall-Sensorelement 14 beabstandet sind, und ferner jeweils einen lateralen Abstand $d_n$ von dem vertikalen Hall-Sensorelement in x-Richtung aufweisen.

Gemäß einem Ausführungsbeispiel umfasst ein Verfahren 50 zur Herstellung des obigen Magnetfeldsensors 10 folgende Schritte: Erzeugen oder Bereitstellen 52 des in dem Halbleitersubstrat 12 angeordneten vertikalen Hall-Sensorelements 14; und Anordnen 54 der Erregerleiteranordnung 16 mit zumindest dem einen Erregerleiter 16-1.

Gemäß einem weiteren Ausführungsbeispiel umfasst ein Verfahren 50 zur Herstellung eines Magnetfeldsensors 10 ferner folgende Schritte: Erzeugen oder Bereitstellen 52 eines in einem Halbleitersubstrat 12, in dessen Oberfläche eine x- und eine z-Richtung verläuft und zu dessen Oberfläche vertikal eine y-Richtung verläuft, angeordneten vertikalen Hall-Sensorelements 14, dessen Kontakte entlang der z-Richtung angeordnet sind; und Anordnen 54 einer Erregerleiteranordnung 16 mit zumindest einem Erregerleiter 16-1, wobei der Erregerleiter 16-1 in einer Erregerleiterebene $E_1$ angeordnet wird, die parallel zu der Substratoberfläche 12a in einem vertikalen Abstand $h_1$, der Prozesstoleranzen ausgesetzt ist, von dem vertikalen Hall-Sensorelement 14 ist, und ferner einen lateralen Abstand $d_1$ vorgesehen in x-Richtung zu dem vertikalen Hall-Sensorelement (14) aufweist, wobei die Abstände jeweils von der geometrischen Schwerpunktlinie des Erregerleiters und des aktiven Bereichs des Hall-Sensorelements aus bestimmt sind, und wobei der laterale Abstand $d_1$ so gewählt wird, dass der Verlauf einer vertikalen Kalibrierkomponente $B_{1x}$ in x-Richtung einer von der Erregerleiteranordnung 16 in dem vertikalen Hall-Sensorelement 14 erzeugten, magnetischen Flussdichte $B_1$ bei einem vorgegebenen Kalibrierungsstrom genähert durch die folgende Gleichung :

$$B_{1x} = \frac{\displaystyle\int_{-e_1/2}^{+e_1/2}\int_{-s/2}^{+s/2} \frac{\mu}{2\pi} \cdot \frac{h_y}{\left(x1-x2+d_1\right)^2 + h_y^{\,2}} \cdot I_1 \; dx1 \; dx2}{s \cdot e_1}$$

wobei der Erregerleiter 16-1 eine Breite $e_1$ und der aktive Halbleiterbereich 14a des vertikalen Hall-Sensorelements 14 eine Breite s aufweist, bei $h=h_1$ einen lokalen Maximalwert annimmt, wobei die Abstände jeweils von der geometrischen Schwerpunktlinie des Erregerleiters und des aktiven Bereichs des Hall-Sensorelements aus bestimmt sind.

Gemäß einem weiteren Ausführungsbeispiel umfasst ein Verfahren 50 zur Herstellung eines Magnetfeldsensors 10 ferner folgende Schritte: Erzeugen oder Bereitstellen 52 eines in einem Halbleitersubstrat 12, in dessen Oberfläche eine x- und eine z-Richtung verläuft und zu dessen Oberfläche vertikal eine y-Richtung verläuft, angeordneten vertikalen Hall-Sensorelements 14, dessen Kontakte entlang der z-Richtung angeordnet sind; und Anordnen 54 einer Erregerleiteranordnung 16 mit zumindest einem Erregerleiter 16-1 und einem weiteren Erregerleiter 16-2, wobei der Erregerleiter 16-1 in einer Erregerleiterebene $E_1$ angeordnet wird, die parallel zu der Substratoberfläche 12a in einem vertikalen Abstand $h_1$, der Prozesstoleranzen ausgesetzt ist, von dem vertikalen Hall-Sensorelement 14 vorgesehen ist, und ferner einen lateralen Abstand $d_1$ in x-Richtung zu dem vertikalen Hall-Sensorelement 14, aufweist, und wobei der weitere Erregerleiter 16-2 in einer weiteren Erregerleiterebene $E_1'$, die parallel zu der Substratoberfläche 12a in einem vertikalen

9

Abstand $h_2$, der Prozesstoleranzen ausgesetzt ist, von dem vertikalen Hall-Sensorelement 14 vorgesehen wird, und ferner einen lateralen Abstand $d_2$ von dem Hall-Sensorelement in x-Richtung aufweist, und wobei die lateralen Abstände d1 und d2 so ausgewählt werden, dass der Verlauf einer resultierenden vertikalen Kalibrierkomponente $B_{2x}$ einer von der Erregerleiteranordnung in dem vertikalen Hall-Sensorelement erzeugten, magnetischen Flussdichte bei vorgegebenen Kalibrierstromdichten $I_1$ und $I_2$ durch die Erregerleitung und die weitere Erregerleitung genähert durch folgende Gleichung :

$$B_{12x} = \frac{\int\limits_{-\frac{e_1}{2}}^{+\frac{e_1}{2}} \int\limits_{-\frac{s}{2}}^{+\frac{s}{2}} \frac{\mu}{2\pi} \cdot \frac{h_1}{(x1 - x2 + d_1)^2 + h^2} \cdot I_1 \; dx1 \; dx2}{s \cdot e_1} +$$

$$\frac{\int\limits_{-\frac{e_2}{2}}^{+\frac{e_2}{2}} \int\limits_{-\frac{s}{2}}^{+\frac{s}{2}} \frac{\mu}{2\pi} \cdot \frac{h'}{(x1 - x2 + d_2)^2 + h'^2} \cdot I_2 \; dx1 \; dx2}{s \cdot e_2} \; ;$$

wobei der Erregerleiter 16-1 eine Breite $e_1$ und der weitere Erregerleiter 16-2 eine Breite $e_2$ und der aktive Bereich 14a des vertikalen Hall-Sensorelements 14 eine Breite s aufweist, bei $h=h_1$ und $h'=h_2$ einen lokalen Maximalwert annimmt, wobei die Abstände jeweils von den geometrischen Schwerpunktlinien des Erregerleiters und des aktiven Bereichs des Hall-Sensorelements bestimmt sind.

**Patentansprüche**

1. Magnetfeldsensor (10) mit folgenden Merkmalen:

    einem in einem Halbleitersubstrat (12) angeordneten vertikalen Hall-Sensorelement (14); und
    einer Erregerleiteranordnung (16) mit zumindest einem Erregerleiter (16-1);
    wobei der Erregerleiter (16-1) in einer Erregerleiterebene ($E_1$) angeordnet ist, die parallel zu der Substratoberfläche (12a) in einem vertikalen Abstand $h_1$, der einen Herstellungsprozess-bedingten Toleranzbereich $\Delta h_1$ aufweist, von dem vertikalen Hall-Sensorelement (14) beabstandet ist, und ferner einen lateralen Abstand $d_1$ als Versatz zu einer Mittenposition, die sich bezüglich der Substratoberfläche (12a) senkrecht zu dem vertikalen Hall-Sensorelement (14) befindet, aufweist, und
    wobei der laterale Abstand $d_1$ so dimensioniert ist, dass sich eine Kalibrierkomponente $B_{1x}$ parallel zur Substratoberfläche einer von der Erregerleiteranordnung (16) in dem vertikalen Hall-Sensorelement (14) erzeugten, magnetischen Flussdichte $B_1$ innerhalb des Toleranzbereiches $\Delta h_1$ für den vertikalen Abstand $h_1$ um weniger als 5% ändert.

2. Magnetfeldsensor nach Anspruch 1, wobei die Kalibrierungskomponente $B_{1x}$ bei einer Kalibrierungsstromstärke $I_1$ der von dem Erregerleiter in dem vertikalen Hall-Sensorelement erzeugten, magnetischen Flussdichte durch die folgende Gleichung darstellbar ist:

$$B_{1x} = \frac{\int\limits_{-\frac{e_1}{2}}^{+\frac{e_1}{2}} \int\limits_{-\frac{s}{2}}^{+\frac{s}{2}} \frac{\mu}{2\pi} \cdot \frac{h_1}{(x1 - x2 + d_1)^2 + h_1^2} \cdot I_1 \; dx1 \; dx2}{s \cdot e_1}$$

wobei der Erregerleiter (16-1) eine Breite $e_1$ und der aktive Halbleiterbereich (14a) des vertikalen Hall-Sensorelements (14) eine Breite s aufweist.

3. Magnetfeldsensor nach Anspruch 1 oder 2, wobei die Erregerleiteranordnung (16-1) einen weiteren Erregerleiter (16-2) aufweist, wobei der weitere Erregerleiter (16-2) in einer weiteren Erregerleiterebene ($E_1'$), die parallel zu der Substratoberfläche (12a) in einem vertikalen Abstand $h_2$, der einen Herstellungsprozess-bedingten Toleranzbereich $\Delta h_2$ aufweist, von dem vertikalen Hall-Sensorelement (14) beabstandet ist, und ferner einen lateralen Abstand $d_2$ als Versatz zu der Mittenposition aufweist, und wobei der laterale Abstand $d_2$ so dimensioniert ist, dass sich eine resultierende Kalibrierkomponente $B_{2x}$ einer von der Erregerleiteranordnung in dem vertikalen Hall-Sensorelement erzeugten, magnetischen Flussdichte innerhalb des Toleranzbereiches $\Delta h_1$ für den vertikalen Abstand $h_1$ und/oder innerhalb des Toleranzbereichs $\Delta h_2$ für den vertikalen Abstand $h_2$ um weniger als 5% ändert.

4. Magnetfeldsensor nach Anspruch 3, wobei die resultierende Kalibrierkomponente $B_{12x}$ einer von der Erregerleiteranordnung (16) in dem vertikalen Hall-Sensorelement (14) erzeugten, magnetischen Flussdichte $B_{12x}$ auf einer Kombination der von dem Erregerleiter (16-1) und dem weiteren Erregerleiter (16-2) jeweils erzeugten Kalibrierkomponente $B_{x1}$ und $B_{x2}$ basiert.

5. Magnetfeldsensor nach Anspruch 3 oder 4, wobei die resultierende Kalibrierkomponente $B_{12x}$ der von der Erregerleiteranordnung (16) in dem vertikalen Hall-Sensorelement (14) erzeugten, magnetischen Flussdichte durch folgende Gleichung darstellbar ist:

$$B_{12x} = \frac{\displaystyle\int_{-e_1/2}^{+e_1/2}\int_{-s/2}^{+s/2} \frac{\mu}{2\pi} \cdot \frac{h_1}{(x1-x2+d_1)^2 + h_1^2} \cdot I_1 \; dx1 \; dx2}{s \cdot e_1} + $$

$$\frac{\displaystyle\int_{-e_2/2}^{+e_2/2}\int_{-s/2}^{+s/2} \frac{\mu}{2\pi} \cdot \frac{h_2}{(x1-x2+d_2)^2 + h_2^2} \cdot I_2 \; dx1 \; dx2}{s \cdot e_2} \; ;$$

wobei der Erregerleiter (16-1) in einer Leiterebene ($E_1$) und der weitere Erregerleiter (16-2) in einer weiteren Leiterebene ($E_1'$) angeordnet ist, und wobei der weitere Erregerleiter (16-2) eine Breite $e_2$ und der aktive Bereich (14a) des vertikalen Hall-Sensorelements (14) eine Breite s aufweist.

6. Magnetfeldsensor nach einem der vorhergehenden Ansprüche, wobei der Erregerleiter (16-1) als eine integrierte oder diskrete Leiterstruktur ausgebildet ist.

7. Magnetfeldsensor nach einem der Ansprüche 3 bis 6, wobei der weitere Erregerleiter (16-2) als eine integrierte oder diskrete Leiterstruktur ausgebildet ist.

8. Magnetfeldsensor nach einem der vorhergehenden Ansprüche, wobei die Erregerleiteranordnung (16) eine Mehrzahl von weiteren Erregerleitern aufweist, wobei die weiteren Erregerleiter in einer oder mehreren weiteren Erregerleiterebene(n), die parallel zu der Substratoberfläche (12a) in einem vertikalen Abstand $h_n$, der einen Herstellungsprozess-bedingten Toleranzbereich $\Delta h_n$ aufweist, von dem vertikalen Hall-Sensorelement (14) beabstandet sind, und ferner jeweils einen lateralen Abstand $d_n$ als Versatz zu der Mittenposition aufweisen, und wobei der laterale Abstand $d_n$ jeweils so dimensioniert ist, dass sich eine resultierende Kalibrierkomponente $B_{2n}$ einer von der Erregerleiteranordnung in dem vertikalen Hall-Sensorelement erzeugten, magnetischen Flussdichte innerhalb des jeweiligen Toleranzbereiches $\Delta h_n$ für den jeweiligen vertikalen Abstand $h_n$ um weniger als 5% ändert.

9. Verfahren (50) zur Herstellung eines Magnetfeldsensors (10), mit folgenden Schritten:

Erzeugen oder Bereitstellen (52) eines in einem Halbleitersubstrat (12) angeordneten vertikalen Hall-Sensorelements (14); und

Anordnen (54) einer Erregerleiteranordnung (16) mit zumindest einem Erregerleiter (16-1),

wobei der Erregerleiter (16-1) in einer Erregerleiterebene ($E_1$) angeordnet wird, die parallel zu der Substratoberfläche (12a) in einem vertikalen Abstand $h_1$, der einen Herstellungsprozess-bedingten Toleranzbereich $\Delta h_1$ aufweist, von dem vertikalen Hall-Sensorelement (14) beabstandet ist, und ferner einen lateralen Abstand $d_1$ als Versatz zu einer Mittenposition, die sich bezüglich der Substratoberfläche (12a) senkrecht zu dem vertikalen Hall-Sensorelement (14) befindet, aufweist, und

wobei der laterale Abstand $d_1$ so dimensioniert wird, dass sich eine Kalibrierkomponente $B_{1x}$ parallel zur Substratoberfläche einer von der Erregerleiteranordnung (16) in dem vertikalen Hall-Sensorelement (14) erzeugten, magnetischen Flussdichte $B_1$ innerhalb des Toleranzbereiches $\Delta h_1$ für den vertikalen Abstand $h_1$ um weniger als 5% ändert.

**10.** Verfahren nach Anspruch 9, ferner mit folgenden Schritt:

Anordnen (56) zumindest eines weiteren Erregerleiters (16-2) an der Erregerleiteranordnung (16),

wobei der weitere Erregerleiter (16-2) in einer weiteren Erregerleiterebene ($E_1'$), die parallel zu der Substratoberfläche (12a) in einem vertikalen Abstand $h_2$, der einen Herstellungsprozess-bedingten Toleranzbereich $\Delta h_2$ aufweist, von dem vertikalen Hall-Sensorelement (14) beabstandet angeordnet wird, und ferner einen lateralen Abstand $d_2$ als Versatz zu der Mittenposition aufweist, und wobei der laterale Abstand $d_2$ so dimensioniert wird, dass sich eine resultierende Kalibrierkomponente $B_{2x}$ einer von der Erregerleiteranordnung in dem vertikalen Hall-Sensorelement erzeugten, magnetischen Flussdichte innerhalb des Toleranzbereiches $\Delta h_1$ für den vertikalen Abstand $h_1$ und/oder innerhalb des Toleranzbereichs $\Delta h_2$ für den vertikalen Abstand $h_2$ um weniger als 5% ändert.

**11.** Verfahren nach Anspruch 9 oder 10, ferner mit folgenden Schritt:

Anordnen (56) einer Mehrzahl von weiteren Erregerleitern (16-2) an der Erregerleiteranordnung (16),

wobei die weiteren Erregerleiter in einer oder mehreren weiteren Erregerleiterebene(n), die parallel zu der Substratoberfläche (12a) in einem vertikalen Abstand $h_n$ der einen Herstellungsprozess-bedingten Toleranzbereich $\Delta h_n$ aufweist, von dem vertikalen Hall-Sensorelement (14) beabstandet sind, und ferner jeweils einen lateralen Abstand $d_n$ als Versatz zu der Mittenposition aufweisen, und wobei der laterale Abstand $d_n$ jeweils so dimensioniert ist, dass sich eine resultierende Kalibrierkomponente $B_{2n}$ einer von der Erregerleiteranordnung in dem vertikalen Hall-Sensorelement erzeugten, magnetischen Flussdichte innerhalb des jeweiligen Toleranzbereiches $\Delta h_n$ für den jeweiligen vertikalen Abstand $h_n$ um weniger als 5% ändert.

**Claims**

**1.** Magnetic field sensor (10) comprising:

a vertical Hall sensor element (14) arranged in a semiconductor substrate (12); and

an exciting conductor arrangement (16) having at least one exciting conductor (16-1);

said exciting conductor (16-1) being arranged within an exciting conductor plane ($E_1$) which is spaced apart, in parallel to the substrate surface (12a), from the vertical Hall sensor element (14) at a vertical distance $h_1$ comprising a tolerance range $\Delta h_1$ which is due to the manufacturing process, and further comprises a lateral distance $d_1$ as an offset from a center position which is located, in relation to the substrate surface (12a), perpendicularly to the vertical Hall sensor element (14), and

said lateral distance $d_1$ being dimensioned such that a calibration component $B_{1x}$, in parallel to the substrate surface, of a magnetic flux density $B_1$ created by the exciting conductor arrangement (16) in the vertical Hall sensor element (14) changes by less than 5% within the tolerance range $\Delta h_1$ for the vertical distance $h_1$.

**2.** Magnetic field sensor as claimed in claim 1, wherein the calibration component may be represented by the following equation with a calibration current intensity $I_1$ of the magnetic flux density created by the exciting conductor in the vertical Hall sensor element:

$$B_{1x} = \frac{\displaystyle\int_{-e_1/2}^{+e_1/2} \int_{-s/2}^{+s/2} \frac{\mu}{2\pi} \cdot \frac{h_1}{(x1-x2+d_1)^2 + h_1^2} \cdot I_1 \; dx1 \; dx2}{s \cdot e_1}$$

wherein the exciting conductor (16-1) has a width $e_1$, and the active semiconductor area (14a) of the vertical Hall sensor element (14) has a width s.

3. Magnetic field sensor as claimed in claims 1 or 2, wherein the exciting conductor arrangement (16-1) comprises a further exciting conductor (16-2), said further exciting conductor (16-2) being within a further exciting conductor plane ($E_1$') which is spaced apart, in parallel to the substrate surface (12a), from the vertical Hall sensor element (14) at a vertical distance $h_2$ comprising a tolerance range $\Delta h_2$ which is due to the manufacturing process, and which exciting conductor (16-1) further comprises a lateral distance $d_2$ as an offset from the center position, and the lateral distance $d_2$ being dimensioned such that a resulting calibration component $B_{2x}$ of a magnetic flux density created by the exciting conductor arrangement in the vertical Hall sensor element changes by less than 5% within the tolerance range $\Delta h_1$ for the vertical distance $h_1$ and/or within the tolerance range $\Delta h_2$ for the vertical distance $h_2$.

4. Magnetic field sensor as claimed in claim 3, wherein the resulting calibration component $B_{12x}$ of a magnetic flux density $B_{12x}$ created by the exciting conductor arrangement (16) in the vertical Hall sensor element (14) is based on a combination of the calibration components $B_{x1}$ and $B_{x2}$ created by the exciting conductor (16-1) and the further exciting conductor (16-2), respectively.

5. Magnetic field sensor as claimed in claims 3 or 4, wherein the resulting calibration component $B_{12x}$ of the magnetic flux density created by the exciting conductor arrangement (16) in the vertical Hall sensor element (14) may be represented by the following equation:

$$B_{12x} = \frac{\displaystyle\int_{-e_1/2}^{+e_1/2} \int_{-s/2}^{+s/2} \frac{\mu}{2\pi} \cdot \frac{h_1}{(x1-x2+d_1)^2 + h_1^2} \cdot I_1 \; dx1 \; dx2}{s \cdot e_1} +$$

$$\frac{\displaystyle\int_{-e_2/2}^{+e_2/2} \int_{-s/2}^{+s/2} \frac{\mu}{2\pi} \cdot \frac{h_2}{(x1-x2+d_2)^2 + h_2^2} \cdot I_2 \; dx1 \; dx2}{s \cdot e_2} \; ;$$

wherein the exciting conductor (16-1) is arranged in a conductor plane ($E_1$) and the further exciting conductor (16-2) is arranged within a further conductor plane ($E_1$'), and wherein the further exciting conductor (16-2) comprises a width $e_2$, and the active area (14a) of the vertical Hall sensor element (14) comprises a width s.

6. Magnetic field sensor as claimed in any of the previous claims, wherein the exciting conductor (16-1) is configured as an integrated or a discrete conductor pattern.

7. Magnetic field sensor as claimed in any of claims 3 to 6, wherein the further exciting conductor (16-2) is configured as an integrated or a discrete conductor pattern.

8. Magnetic field sensor as claimed in any of the previous claims, wherein the exciting conductor arrangement (16) comprises a plurality of further exciting conductors, said further exciting conductors being in one or more further exciting conductor planes which are spaced apart, in parallel to the substrate surface (12a), from the vertical Hall sensor element (14) at a vertical distance $h_n$ comprising a tolerance range $\Delta h_n$ which is due to the manufacturing process, and each of them further comprises a lateral distance $d_n$ as an offset from the center position, the lateral distance $d_n$ being dimensioned such that a resulting calibration component $B_{2n}$ of a magnetic flux density created by the exciting conductor arrangement in the vertical Hall sensor element changes by less than 5% within the respective tolerance range $\Delta h_n$ for the respective vertical distance $h_n$.

9.  Method (50) of producing a magnetic field sensor (10), comprising:

    producing or providing (52) a vertical Hall sensor element (14) arranged in a semiconductor substrate (12); and
    arranging (54) an exciting conductor arrangement (16) comprising at least one exciting conductor (16-1),
    the exciting conductor (16-1) being arranged within an exciting conductor plane ($E_1$) which is spaced apart, in parallel to the substrate surface (12a), from the vertical Hall sensor element (14) at a vertical distance $h_1$ comprising a tolerance range $\Delta h_1$ which is due to the manufacturing process, and which exciting conductor (16-1) further comprises a lateral distance $d_1$ as an offset from a center position which is located, in relation to the substrate surface (12a), perpendicularly to the vertical Hall sensor element (14), and
    the lateral distance $d_1$ being dimensioned such that a calibration component $B_{1x}$, in parallel to the substrate surface, of a magnetic flux density $B_1$ created by the exciting conductor arrangement (16) in the vertical Hall sensor element (14) changes by less than 5% within the tolerance range $\Delta h_1$ for the vertical distance $h_1$.

10.  Method as claimed in claim 9, further comprising:

    arranging (56) at least one further exciting conductor (16-2) at the exciting conductor arrangement (16),
    said further exciting conductor (16-2) being within a further exciting conductor plane ($E_1'$) which is arranged to be spaced apart, in parallel to the substrate surface (12a), from the vertical Hall sensor element (14) at a vertical distance $h_2$ comprising a tolerance range $\Delta h_2$ which is due to the manufacturing process, and which exciting conductor (16-1) further comprises a lateral distance $d_2$ as an offset from the center position, and the lateral distance $d_2$ being dimensioned such that a resulting calibration component $B_{2x}$ of a magnetic flux density created by the exciting conductor arrangement in the vertical Hall sensor element changes by less than 5% within the tolerance range $\Delta h_1$ for the vertical distance $h_1$ and/or within the tolerance range $\Delta h_2$ for the vertical distance $h_2$.

11.  Method as claimed in claims 9 or 10, further comprising:

    arranging (56) a plurality of further exciting conductors (16-2) at the exciting conductor arrangement (16),
    said further exciting conductors being in one or more further exciting conductor planes which are spaced apart, in parallel to the substrate surface (12a), from the vertical Hall sensor element (14) at a vertical distance $h_n$ comprising a tolerance range $\Delta h_n$ which is due to the manufacturing process, and each of them further comprises a lateral distance $d_n$ as an offset from the center position, the lateral distance $d_n$ being dimensioned such that a resulting calibration component $B_{2n}$ of a magnetic flux density created by the exciting conductor arrangement in the vertical Hall sensor element changes by less than 5% within the respective tolerance range $\Delta h_n$ for the respective vertical distance $h_n$.

**Revendications**

1.  Capteur de champ magnétique (10), aux caractéristiques suivantes:

    un élément capteur vertical à effet de Hall (14) disposé dans un substrat semi-conducteur (12), et
    un ensemble de conducteurs d'excitation (16) présentant au moins un conducteur d'excitation (16-1);
    dans lequel le conducteur d'excitation (16-1) est disposé dans un plan de conducteur d'excitation ($E_1$) distant de l'élément capteur vertical à effet de Hall (14), parallèlement à la surface du substrat (12a), d'une distance verticale $h_1$ présentant une plage de tolérance $\Delta h_1$ liée par les processus de fabrication, et présentant par ailleurs une distance latérale $d_1$, comme décalage par rapport à une position centrale, qui se trouve, par rapport à la surface de substrat (12a), perpendiculaire à l'élément capteur vertical à effet de Hall (14), et
    dans lequel la distance latérale $d_1$ est dimensionnée de sorte qu'une composante d'étalonnage $B_{1x}$ parallèle à la surface de substrat d'une densité de flux magnétique $B_1$ générée par l'aménagement de conducteurs d'excitation (16) dans l'élément capteur vertical à effet de Hall (14) varie, dans la plage de tolérances $\Delta h_1$ pour la distance verticale $h_1$, de moins de 5%.

**2.** Capteur de champ magnétique selon la revendication 1, dans lequel la composante d'étalonnage $B_{1x}$ peut, à une intensité de courant d'étalonnage $I_1$ de la densité de flux magnétique générée par le conducteur d'excitation dans l'élément capteur vertical à effet de Hall, être représentée par l'équation suivante:

$$B_{1x} = \frac{\int_{-e_1/2}^{+e_1/2} \int_{-s/2}^{+s/2} \frac{\mu}{2\pi} \cdot \frac{h_1}{(x1-x2+d_1)^2 + h_1^2} \cdot I_1 \quad dx1\, dx2}{s \cdot e_1}$$

dans lequel le conducteur d'excitation (16-1) présente une largeur $e_1$ et la zone semi-conductrice active (14a) de l'élément capteur vertical à effet de Hall (14) présente une largeur s.

**3.** Capteur de champ magnétique selon la revendication 1 ou 2, dans lequel l'aménagement de conducteurs d'excitation (16-1) présente un autre conducteur d'excitation (16-2), l'autre conducteur d'excitation (16-2) étant distant, dans un autre plan de conducteurs d'excitation ($E_1'$) parallèle à la surface de substrat (12a), d'une distance verticale $h_2$ présentant une plage de tolérance $\Delta h_2$ liée par le processus de fabrication de l'élément capteur vertical à effet de Hall (14), et présente par ailleurs une distance latérale $d_2$, comme décalage de la position centrale, et dans lequel la distance latérale $d_2$ est dimensionnée de sorte qu'une composante d'étalonnage résultante $B_{2x}$ d'une densité de flux magnétique générée par l'aménagement de conducteurs d'excitation dans l'élément capteur vertical à effet de Hall varie, dans la plage de tolérance $\Delta h_1$ pour la distance verticale $h_1$ et/ou dans la plage de tolérance $\Delta h_2$ pour la distance verticale $h_2$, de moins de 5%.

**4.** Capteur de champ magnétique selon la revendication 3, dans lequel la composante d'étalonnage résultante $B_{12x}$ d'une densité de flux magnétique $B_{12x}$ générée par l'aménagement de conducteurs d'excitation (16) dans l'élément capteur vertical à effet de Hall (14), se base sur une combinaison de la composante d'étalonnage $B_{x1}$ et $B_{x2}$ générée respectivement par le conducteur d'excitation (16-1) et l'autre conducteur d'excitation (16-2).

**5.** Capteur de champ magnétique selon la revendication 3 ou 4, dans lequel la composante d'étalonnage résultante $B_{12x}$ de la densité de flux magnétique générée par l'aménagement de conducteurs d'excitation (16) dans l'élément capteur vertical à effet de Hall (14) peut être représentée par l'équation suivante:

$$B_{12x} = \frac{\int_{-e_1/2}^{+e_1/2} \int_{-s/2}^{+s/2} \frac{\mu}{2\pi} \cdot \frac{h_1}{(x1-x2+d_1)^2 + h_1^2} \cdot I_1 \quad dx1\, dx2}{s \cdot e_1} +$$

$$\frac{\int_{-e_2/2}^{+e_2/2} \int_{-s/2}^{+s/2} \frac{\mu}{2\pi} \cdot \frac{h_1}{(x1-x2+d_2)^2 + h_2^2} \cdot I_2 \quad dx1\, dx2}{s \cdot e_2} ;$$

dans lequel le conducteur d'excitation (16-1) est disposé dans un plan de conducteur ($E_1$) et l'autre conducteur d'excitation (16-2) est disposé dans un autre plan de conducteur ($E_1'$), et dans lequel l'autre conducteur d'excitation (16-2) présente une largeur $e_2$ et la zone active (14a) de l'élément capteur vertical à effet de Hall (14) présente une largeur s.

**6.** Capteur de champ magnétique selon l'une des revendications précédentes, dans lequel le conducteur d'excitation (16-1) est réalisé sous forme de structure de conducteur intégrée ou discrète.

**7.** Capteur de champ magnétique selon l'une des revendications 3 à 6, dans lequel l'autre conducteur d'excitation (16-2) est réalisé sous forme de structure de conducteur intégrée ou discrète.

8.  Capteur de champ magnétique selon l'une des revendications précédentes, dans lequel l'aménagement de conducteurs d'excitation (16) présente une pluralité d'autres conducteurs d'excitation, lesdits autres conducteurs d'excitation étant distants, dans un ou plusieurs autres plans de conducteurs d'excitation parallèles à la surface de substrat (12a), d'une distance verticale $h_n$ présentant une plage de tolérance $\Delta h_n$ liée par le processus de fabrication de l'élément capteur vertical à effet de Hall (14), et présentant par ailleurs, chacun, une distance latérale $d_n$, comme décalage par rapport à la position centrale, et dans lequel la distance latérale $d_n$ est chaque fois dimensionnée de sorte qu'une composante d'étalonnage résultante $B_{2n}$ d'une densité de flux magnétique générée par l'aménagement de conducteurs d'excitation dans l'élément capteur vertical à effet de Hall varie, dans la plage de tolérance $\Delta h_n$ respective pour la distance verticale respective $h_n$, de moins de 5%.

9.  Procédé (50) de fabrication d'un capteur de champ magnétique (10), aux étapes suivantes consistant à:

    générer ou mettre à disposition (52) un élément capteur vertical à effet de Hall (14) disposé dans un substrat semi-conducteur (12), et
    disposer (54) un aménagement de conducteurs d'excitation (16) avec au moins un conducteur d'excitation (16-1), dans lequel le conducteur d'excitation (16-1) est disposé dans un plan de conducteurs d'excitation ($E_1$) qui est distant, parallèlement à la surface de substrat (12a), d'une distance verticale $h_1$ présentant une plage de tolérance $\Delta h_1$ liée par le processus de fabrication de l'élément capteur vertical à effet de Hall (14), et qui présente par ailleurs une distance latérale $d_1$, comme décalage par rapport à une position centrale qui se trouve par rapport à la surface de substrat (12a) perpendiculaire à l'élément capteur vertical à effet de Hall (14), et dans lequel la distance latérale $d_1$ est dimensionnée de sorte qu'une composante d'étalonnage $B_{1x}$ parallèle à la surface de substrat d'une densité de flux magnétique $B_1$ générée par l'aménagement de conducteurs d'excitation (16) dans l'élément capteur vertical à effet de Hall (14) varie, dans la plage de tolérance $\Delta h_1$ pour la distance verticale $h_1$, de moins de 5%.

10. Procédé selon la revendication 9, par ailleurs à l'étape suivante consistant à:

    disposer (56) au moins un autre conducteur d'excitation (16-2) sur l'aménagement de conducteurs d'excitation (16),
    dans lequel ledit autre conducteur d'excitation (16-2) est distant, dans un autre plan de conducteur d'excitation ($E_1'$) parallèle à la surface de substrat (12a), d'une distance verticale $h_2$ présentant une plage de tolérance $\Delta h_2$ liée par le processus de fabrication, de l'élément capteur vertical à effet de Hall (14), et présentant par ailleurs une distance latérale $d_2$, comme décalage par rapport à la position centrale, et dans lequel la distance latérale $d_2$ est dimensionnée de sorte qu'une composante d'étalonnage résultante $B_{2x}$ d'une densité de flux magnétique générée par l'aménagement de conducteurs d'excitation dans l'élément capteur vertical à effet de Hall varie, dans la plage de tolérance $\Delta h_1$ pour la distance verticale $h_1$ et/ou dans la plage de tolérance $\Delta h_2$ pour la distance verticale $h_2$, de moins de 5%.

11. Procédé selon la revendication 9 ou 10, par ailleurs à l'étape suivante consistant à:

    disposer (56) une pluralité d'autres conducteurs d'excitation (16-2) sur l'aménagement de conducteurs d'excitation (16),
    dans lequel les autres conducteurs d'excitation sont distants, dans un ou plusieurs autres plans de conducteurs d'excitation parallèles à la surface de substrat (12a), d'une distance verticale $h_n$ présentant une plage de tolérance $\Delta h_n$ liée au processus de fabrication, de l'élément capteur vertical à effet de Hall (14), et présentant, chacun, par ailleurs une distance latérale $d_n$, comme décalage par rapport à la position centrale, et dans lequel la distance latérale $d_n$ est, chaque fois, dimensionnée de sorte qu'une composante d'étalonnage résultante $B_{2n}$ d'une densité de flux magnétique générée par l'aménagement de conducteurs d'excitation dans l'élément capteur vertical à effet de Hall varie, dans la plage de tolérance $\Delta h_n$ respective pour la distance verticale $h_n$ respective, de moins de 5%.

**FIG 1A**

**FIG 1B**

FIG 2

FIG 3

FIG 4A

FIG 4B

50

Erzeugen oder Bereitstellen eines in einem Halbleitersubstrat angeordneten vertikalen Hall-Sensorelements ⟩~52

Anordnen einer Erregerleiteranordnung mit zumindest einem Erregerleiter in dem Halbleitersubstrat ⟩~54

Anordnen zumindest eines weiteren Erreger-leiters an der Erregerleiteranordnung ⟩~56 (optional)

FIG 5

FIG 6A

FIG 6B

FIG 7

FIG 8

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

• DE 102006034226 A1

**In der Beschreibung aufgeführte Nicht-Patentliteratur**

• Integrated sensitivity adjustment for 3D Hall sensors. **STAHL-OFFERGELD M et al.** SENSOR LETTERS. AMERICAN SCIENTI-FIC PUBLISHERS, 01. Juni 2009, vol. 7, 313-316